(19) Europäisches Patentamt

European Patent Office

Office européen des brevets

(11) Veröffentlichungsnummer: **0 209 769 B1**

# (12) EUROPÄISCHE PATENTSCHRIFT

(45) Veröffentlichungstag der Patentschrift: **28.08.91**

(21) Anmeldenummer: **86109139.5**

(22) Anmeldetag: **04.07.86**

(51) Int. Cl.⁵: **G01R 31/28**

(54) **Prüfanordnung für ein signalverarbeitendes elektrisches Gerät.**

(30) Priorität: **18.07.85 DE 3525715**

(43) Veröffentlichungstag der Anmeldung:
**28.01.87 Patentblatt 87/05**

(45) Bekanntmachung des Hinweises auf die
Patenterteilung:
**28.08.91 Patentblatt 91/35**

(84) Benannte Vertragsstaaten:
**DE FR IT**

(56) Entgegenhaltungen:
**DE-B- 2 735 054**
**DE-B- 2 827 601**
**DE-C- 3 040 316**

(73) Patentinhaber: **Siemens Aktiengesellschaft**
**Wittelsbacherplatz 2**
**W-8000 München 2(DE)**

(72) Erfinder: **Pickavé, Wolfgang, Dipl.-Ing.**
**Leopoldshafener Strasse 6**
**W-7500 Karlsruhe(DE)**

## Beschreibung

Die Erfindung betrifft ein Verfahren und eine Anordnung zur Prüfung eines mit seinen Ein- und Ausgängen mit Sensoren bzw. Stellgliedern fest verdrahteten, signalverarbeitenden elektrischen Geräts und der zugehörigen Verbindungsleitungen mit induktiven Stromzangen, die ausgangsseitig an Meßgeräte angeschlossen sind.

Aus der DE 27 35 054 Bl ist zur Messung von Strömen in nichtauftrennbaren elektrischen Leitern, Kabeln oder dergleichen eine sogenannte Stromzange bekannt. Sie besteht aus einem den Leiter umschließenden Magnetgestell, das eine Sekundärwicklung trägt. Im dieser einfachen Stromzange wird die Primärwicklung vom adaptierten Leiter gebildet. Die Sekundärwicklung ist am eine Referenzstromquelle angeschlossen. Für die Messung von Gleichströmen nimmt die Stromzange in einem Luftspalt ihres Magnetgestells ein magnetfeldabhängiges Element, beispielsweise einen magnetfeldabhängigen Widerstand oder ein Hallplättchen, auf. Das Magnetfeld um den adaptierten Leiter wird im Magnetgestell der Zange konzentriert und beeinflußt das magnetfeldabhängige Element. Das Ausgangssignal dieses Elementes ist dem im adaptierten Leiter fließenden Strom proportional. Diese Zange ist sowohl für Gleich- als auch Wechselstrommessungen brauchbar. Es sind mit Sensoren und Stellgliedern verbundene signalverarbeitende elektrische Geräte üblich, die nach ihrer Installation und festen Verdrahtung mit den Sensoren und Stellgliedern auf ihre Betriebsfähigkeit untersucht werden müssen. Beispielsweise stellen Steuergeräte bei Automobilen, mit welchen die Gemischaufbereitung und die Zündzeitpunkte eines Verbrennungsmotors abhängig von Abgaswerten und Fahrstufen gesteuert werden, derartige Geräte dar. Die volle Betriebsfähigkeit derartiger Geräte muß im Laufe der Lebensdauer des Kraftfahrzeugs verhältnismäßig häufig überprüft werden. Ein Auftrennen der Leitungen zwischen dem Steuergerät und den Sensoren bzw. Stellgliedern zu Prüfzwecken ist unwirtschaftlich. Etwa dafür vorgesehene Steckadapter nützen sich im Laufe der Zeit ab und bilden dann selbst Fehlerquellen.

Der Erfindung lag die Aufgabe zugrunde, eine Überprüfung des Steuergerätes und der über Verbindungsleitungen mit seinen Ein- und Ausgängen verbundenen Sensoren und Stellglieder sowie der Verbindungsleitungen selbst vorzunehmen, ohne daß die Verbindungsleitungen aufgetrennt werden müssen.

Diese Aufgabe wird bei einem Verfahren und einer Anordnung der eingangs genannten Art gemäß der Erfindung durch die Schnitte bzw. Merkmale der Ansprüche 1 bzw. 2 gelöst.

Mit Hilfe der über die Stimuli-Wicklungen der einzelnen Stromzangen in die adaptierten Verbindungswege eingegebenen Stimuli-Signale werden im Steuergerät Antwortsignale ausgelöst, die von anderen Stromzangen an Leitungen, die zu Stellgliedern führen, abgegriffen werden. In einem Bauteile der Prüfanordnung zusammenfassenden Gerät sind Schaltmittel vorgesehen, mit denen wahlweise die Zuordnung eines Stimulus-Generators und eines Meßgerätes zu dem jeweiligen Magnetgestellen bewerkstelligt wird.

Um Prüfungen sowohl im Gleich- als auch im Wechselstrombereich durchführen zu können, sind zweckmäßig in einem Luftspalt an mindestens einem der Magnetgestelle der Stromzangen magnetfeldabhängige Elemente, wie Hall- oder Feldplatten, angeordnet.
Meßgeräte, die an die magnetfeldabhängigen Elemente angeschlossen sind, können nach einer Ausschlagmethode oder kompensierenden Methode arbeiten.

Die Erfindung gestattet eine potentialfreie, nichtgalvanische Beaufschlagung eines Systems mit Prüfsignalen und eine ebensolche Erfassung von Antwortsignalen und damit eine Prüfung, ohne das zu prüfende System elektrisch zu verändern.

Es entfallen auch Zwischenstecker, die entsprechend den verschiedenen Meßobjekten nach verschiedenen Normen ausgebildet sein müßten.

Es sind auch zeitparallele Signalverlaufsuntersuchungen leicht realisierbar.

Die Erfindung wird anhand von drei Figuren, die ein Ausführungsbeispiel darstellen, erläutert.
Figur 1 ist ein schematisches Blockschaltbild einer Prüfanordnung mit einem Prüfobjekt.
Figur 2 stellt ein Magnetgestell mit einem angeschlossenen Meßgerät nach der Ausschlagmethode dar.
Figur 3 zeigt ein Magnetgestell mit einem Meßgerät, das nach einer Kompensationsmethode arbeitet.

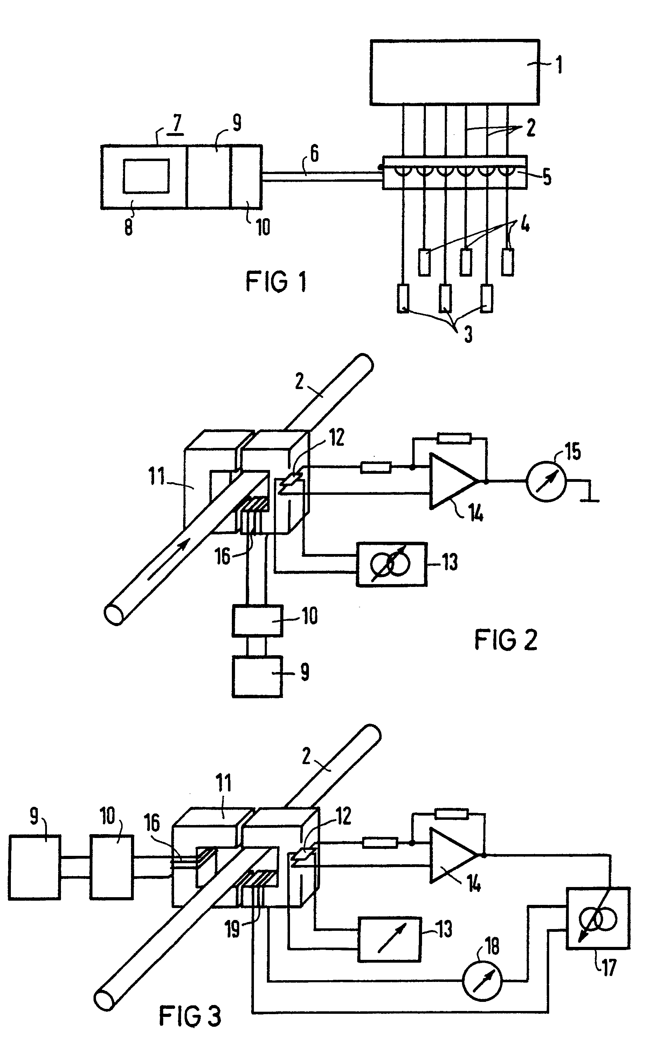

In Figur 1 ist ein signalverarbeitendes elektrisches Gerät 1, beispielsweise ein Steuergerät zur sensorsignalabhängigen Steuerung einer Brennkraftmaschine, über feste Verbindungsleitungen 2 mit Sensoren 3 bzw. Stellgliedern 4 verbunden. Eine Mehrfachstromzange 5 greift die Verbindungsleitungen 2 an einer zugänglichen Stelle ab. Die Mehrfachstromzange 5 ist über ein Meß- und Stimuli-Leitungen vereinendes Kabel 6 mit einem Prüfgerät 7 verbunden, das im wesentlichen aus einem Meßgerät 8, einem Stimuli-Generator 9 und Schaltmitteln 10 besteht. Die Schaltmittel können durch ein nicht dargestelltes Tableau oder durch einen ebenfalls im Prüfgerät 7 vorhandenen Mikroprozessor programmgesteuert sein.

In Figur 2 wird eine der Verbindungsleitungen 2 aus der Figur 1 von einem einzelnen Magnetgestell 11 umfaßt. In einem Luftspalt trägt das Magnetgestell ein Hallplättchen 12, das an seinen Stromanschlüssen von einem einstellbaren Stromgenerator 13 gespeist wird. Mit dem Strom kann die Empfindlichkeit des Hallplättchens eingestellt werden. Ausgangsklemmen des Hallplättchens 12 sind mit Eingangsklemmen eines Verstärkers 14 verbunden, dessen Ausgang ein Meßgerät 15 beaufschlagt, das nach der Ausschlagmethode anzeigt. Das Magnetgestell 11 trägt eine zusätzliche Wicklung 16, die über die Schaltmittel 10 mit dem Stimuli-Generator 9 verbunden ist.

Die Figur 3 stimmt in wesentlichen Punkten mit der Figur 2 überein. Der Verstärker 14 steuert jedoch bei der Schaltung nach Figur 3 einen Stromgenerator 17, der einen Kompensationsstrom über ein Instrument 18 an eine Kompensationswicklung 19 am Magnetgestell 11 liefert. Die Kompensationsschaltung stellt einen Proportionalregelkreis dar, in dem der Kompensationsstrom durch die Kompensationswicklung 19, gesteuert von der Ausgangsspannung des Verstärkers 14, so lange anwächst, bis das von der Kompensationswicklung 19 erzeugte Magnetfeld das vom Magnetgestell 11 abgegriffene Magnetfeld, das vom durch den Leiter 2 fließenden Strom erzeugt ist, nahezu kompensiert. Der dazu notwendige und im Instrument 18 angezeigte Kompensationsstrom ist damit ein Maß für den im Leiter 2 fließenden Strom. Auch bei dieser Anordnung trägt das Magnetgestell eine zusätzliche Stimuli-Wicklung 16, die von einem Stimuli-Generator 9 über Schaltmittel 10 die Möglichkeit bietet, Stimuli-Signale auf den Leiter 2 zu übertragen.

## Patentansprüche

1. Verfahren zur Prüfung eines mit seinen Ein- und Ausgängen mit Sensoren (3) bzw. Stellgliedern (4) fest verdrahteten, signalverarbeitenden elektrischen Geräts (1) und der zugehörigen Verbindungsleitungen (2) mittels induktiver Stromzangen (5), von denen mindestens zwei Stromzangen (5) an ihrem jeweiligen Magnetgestell (11) mit je einer zusätzlichen, an einen Stimulus-Generator (9) anschließbaren Stimulus-Wicklung (16) ausgerüstet werden, die mindestens zwei Stromzangen (5) an verschiedene Verbindungsleitungen (2) zwischen dem signalverarbeitenden elektrischen Gerät (1) und den Sensoren (3) bzw. Stellgliedern (4) angelegt und ausgangsseitig an Meßgeräte (8) angeschlossen werden und über mindestens eine der Stimulus-Wicklungen (16) Stimuli-Signale in die adaptierten Verbindungsleitungen (2) eingegeben werden, die in dem signalverarbeitenden elektrischen Gerät (1) Antwortsignale auslösen, die mit mindestens einer der weiteren induktiven Stromzangen (5) gemessen und ausgewertet werden.

2. Anordnung zur Durchführung des Verfahrens nach Anspruch 1, mit induktiven Stromzangen (5), von denen mindestens zwei Stromzangen (5) an ihrem jeweiligen Magnetgestell (11) mit je einer zusätzlichen, an einen Stimulus-Generator (9) anschließbaren Stimulus-Wicklung (16) ausgerüstet sind, die mindestens zwei Stromzangen (5) an verschiedene Verbindungsleitungen (2) zwischen dem signalverarbeitenden elektrischen Gerät (1) und den Sensoren (3) bzw. Stellgliedern (4) anlegbar und ausgangsseitig an Meßgeräte (8) angeschlossen sind, und mit Schaltmitteln (10) zur wahlweisen Zuordnung eines Stimulus-Generators (9) und eines Meßgerätes (8, 15, 18) zu den jeweiligen Magnetgestellen (11), wobei mehrere voneinander unabhängige Magnetgestelle (11) in einer Stromzange (5) vereinigt sind.

3. Anordnung nach Anspruch 2, **dadurch gekennzeichnet,** daß in einem Luftspalt an mindestens einem der Magnetgestelle (11) magnetfeldabhängige Elemente (12) angeordnet sind.

4. Anordnung nach Anspruch 3, **dadurch gekennzeichnet,** daß das dem magnetfeldabhängigen Element (12) zugeordnete Meßgerät (15) nach einer Ausschlagmethode mißt.

5. Anordnung nach Anspruch 3, **dadurch gekennzeichnet,** daß das dem magnetfeldabhängigen Element (12) zugeordnete Meßgerät (18) nach einer Kompensationsmethode mißt.

## Claims

1. Process for testing an electrical signal-processing device (1), firmly wired with its inputs and outputs to sensors (3) and control elements (4), and the appertaining connection lines (2) by means of induction current clips (5), at least two of the current clips (5) being equipped at their respective magnetic frame (11) with an additional excitation winding (16) respectively, which can be attached to an excitation generator (9), the at least two current clips (5) being applied to various connection lines (2) between the electrical signal-processing device (1) and the sensors (3) or control elements (4) and being attached on the output side to measuring devices (8), and by means of at least one of the excitation windings (16) excitation signals are entered into the adapted connection lines (2), which release response signals in the electrical signal-processing device (1), which are measured and evaluated with at least one of the further induction current clips (5).

2. Arrangement for carrying out the process according to claim 1, having induction current clips (5), at least two of which current clips (5) are equipped at their respective magnetic frame (11) with an additional excitation winding (16) respectively, which can be attached to an excitation generator (9), the at least two current clips (5) can be applied to various connection lines (2) between the electrical signal-processing device (1) and the sensors (3) or control elements (4) and are attached to measuring devices (8) on the output side, and having switching means (10) for the selective allocation of an excitation generator (9) and a measuring device (8, 15, 18) to the respective magnetic frames (11), wherein several magnetic frames (11), independent of one another, are united in one current clip (5).

3. Arrangement according to claim 2, characterized in that magnetic-field-dependent elements (12) are arranged in an air gap at at least one of the magnetic frames (11).

4. Arrangement according to claim 3, characterized in that the measuring device (15) associated with the magnetic-field-dependent element (12) measures according to a deflection method.

5. Arrangement according to claim 3, characterized in that the measuring device (18) associated with the magnetic-field-dependent element (12) measures according to a compensation method.

**Revendications**

1. Procédé pour tester un appareil électrique (1) de traitement de signaux, dont les entrées et les sorties sont raccordées de façon fixe à des capteurs (3) ou à des organes de réglage (4), et les conducteurs associés de liaison (2) à l'aide de pinces ampèremétriques inductives (5), parmi lesquelles au moins deux pinces ampèremétriques (5) sont équipées, au niveau de leur bâti magnétique respective (11), respectivement d'un enroulement respectif supplémentaire de stimulation (16) pouvant être raccordé à un générateur de simuli (9), les au moins deux pinces ampèremétriques (5) étant appliquées sur différents conducteurs de liaison (2) situés entre l'appareil électrique (1) de traitement des signaux des capteurs (3) ou les organes de réglage (4), et étant raccordés côté sortie à des appareils de mesure (8), tandis que des signaux de stimuli peuvent être introduits, par l'intermédiaire d'au moins l'un des enroulements de stimulation (16), dans les conducteurs de liaison adaptés (2), ces signaux déclenchant, dans l'appareil électrique (1) de traitement des signaux, des signaux de réponse qui sont mesurés et évalués à l'aide d'au moins l'une des autres pinces ampèremétriques inductives (5).

2. Dispositif pour la mise en oeuvre du procédé selon la revendication 1, comportant des pinces ampèremétriques inductives (5), dont deux au moins sont équipées, au niveau de leur bâti magnétique respectif (11), d'un enroulement respectif supplémentaire de stimulation (16) pouvant être raccordé à un générateur de stimuli (9), ces pinces pouvant être appliquées sur différents conducteurs de liaison (2) entre l'appareil électrique (1) de traitement de signaux et les capteurs (3) ou les organes de réglage (4) et étant raccordées, côté sortie, à des appareils de mesure (8), et comportant des moyens de commutation (10) pour associer au choix un générateur de stimuli (9) et un appareil de mesure (8,15,18) aux bâtis magnétiques respectifs (11), plusieurs bâtis magnétiques (11) indépendants les uns des autres étant réunis dans une pince ampèremétrique (5).

3. Dispositif suivant la revendication 2, caractérisé par le fait que des éléments (12) dépendant du champ magnétique sont disposés dans un entrefer au niveau d'au moins l'un des bâtis magnétiques (11).

4. Dispositif suivant la revendication 3, caractérisé par le fait que l'appareil de mesure (4) associé à l'élément (12) qui dépend du champ magnétique exécute une mesure selon une méthode de déviation.

5. Dispositif suivant la revendication 3, caractérisé par le fait que l'appareil de mesure (18) associé à l'élément (12), qui dépend du champ magnétique, effectue une mesure selon une méthode de compensation.

FIG 1

FIG 2

FIG 3